# EUROPEAN PATENT APPLICATION

(11) **EP 4 129 740 A1**
(43) Date of publication of application: **08.02.2023**
(21) Application number: 20927718.5
(22) Date of filing: 31.08.2020
(51) Int. Cl.: B60L 1/00

(54) **ONBOARD CONTROL DEVICE**

(30) Priority: 23.03.2020 JP 2020051029
(71) Applicant: Hitachi, Ltd., Tokyo 100-8280 (JP)
(72) Inventor: MIYAJI, Masayuki, Tokyo 100-8280 (JP); MORITA, Kazuki, Tokyo 100-8280 (JP)
(74) Representative: MERH-IP Matias Erny Reichl Hoffmann Patentanwälte PartG mbB
(86) International application number: PCT/JP2020/032928
(87) International publication number: WO 2021/192351

(57) **Abstract**

In an on-vehicle control device, control units of multiple sections forming a redundant section include fail-safe calculation units that complement each other by respective calculation results. The control units in which the fail-safe calculation units are disposed are configured as a collective aggregate, the control units include calculation boards configured to perform calculation processing on the multiple sections, respectively, and output boards configured to output calculation results of the calculation processing by the calculation boards, and a common unit including a common interface connected to a plurality of the output boards respectively corresponding to the multiple sections is aggregated in a partial specific region of the aggregate.

## Description

### Technical Field

The present invention relates to an on-vehicle control device.

### Background Art

PTL 1 discloses a bus configuration including a plurality of processors. More specifically, the bus configuration is a multi-processor system in which boards are fitted to connectors disposed at predetermined intervals on one surface of a motherboard, thereby forming a common bus or an individual bus.

### Citation List

### Patent Literature

PTL 1: JP-A-1-309113

### Summary of Invention

### Technical Problem

However, a technique described in PTL 1 has the bus configuration including the plurality of processors, but is not a unit that implements multiplexing by an independent section, and when multiplexing is forcibly performed in this configuration, configurations of a board and a sub-rack become complicated or large. That is, when a control unit and a common interface unit (hereinafter, referred to as a "common unit" or a "common interface") multiplexed by applying the technique of the multi-processor system of PTL 1 are collectively accommodated in one sub-rack, a problem arises in that wiring in a backboard becomes complicated and mounting becomes difficult. The invention has been made in view of the above problems, and an object thereof is to provide an on-vehicle control device in which a multiple-section configuration is made compact.

### Solution to Problem

In order to solve the technical problem described above, the invention provides an on-vehicle control device in which control units of multiple sections forming a redundant section include fail-safe calculation units that complement each other by respective calculation results. The control units in which the fail-safe calculation units are disposed are configured as an aggregate. The on-vehicle control device includes calculation boards configured to perform calculation processing for the multiple sections, respectively, and output boards configured to output calculation results of the calculation processing by the calculation boards. A common unit including a common interface connected to a plurality of the output boards respectively corresponding to multiple sections is aggregated in a partial specific region of the aggregate. In the aggregate, the control units of multiple sections are disposed so as to be equidistant with the common unit.

### Advantageous Effects of Invention

According to the invention, the on-vehicle control device having a compact multiple-section configuration can be provided.

### Brief Description of Drawings

[FIG. 1A] FIG. 1A is a block diagram showing a board arrangement of an on-vehicle control device 12A according to an embodiment of the invention, and is a laterally symmetrical board arrangement example.
[FIG. 1B] FIG. 1B is a block diagram showing an on-vehicle control device 12B according to a modification of FIG. 1A, and is a vertically symmetrical (vertically aligned) board arrangement example.
[FIG. 2] FIG. 2 is a schematic explanatory diagram of an arrangement example in which an on-vehicle control device 12 is disposed in a vehicle.
[FIG. 3] FIG. 3 is a block diagram showing the on-vehicle control device 12 of FIG. 2 in more detail.
[FIG. 4] FIG. 4 is a block diagram showing an efficient arrangement of the on-vehicle control device 12 of FIG. 2 in a sub-rack.
[FIG. 5] FIG. 5 is a block diagram showing an interface configuration of each section and a common unit in the on-vehicle control device 12 of FIG. 3, and is an example of a system in which double sections operate in parallel.
[FIG. 6] FIG. 6 is a block diagram showing an interface configuration in which one of the double sections is set to be a main section and the other is set to be a spare standby section with respect to the configuration of FIG. 5.
[FIG. 7] FIG. 7 is a block diagram showing an arrangement example of an on-vehicle control device 12C in which the double sections are integrated into one sub-rack.
[FIG. 8] FIG. 8 is a block diagram showing an arrangement example of an on-vehicle control device 12D that includes the common unit and normally configures the double sections.
[FIG. 9] FIG. 9 is a block diagram showing an arrangement example of an on-vehicle control device 12E in which the double sections of FIG. 8 are set to be vertically symmetrical.
[FIG. 10] FIG. 10 is a block diagram showing an arrangement example in which power source divisions of a backboard of the on-vehicle control device 12E of FIG. 9 are efficiently applied.

### Description of Embodiments

### [Definition]

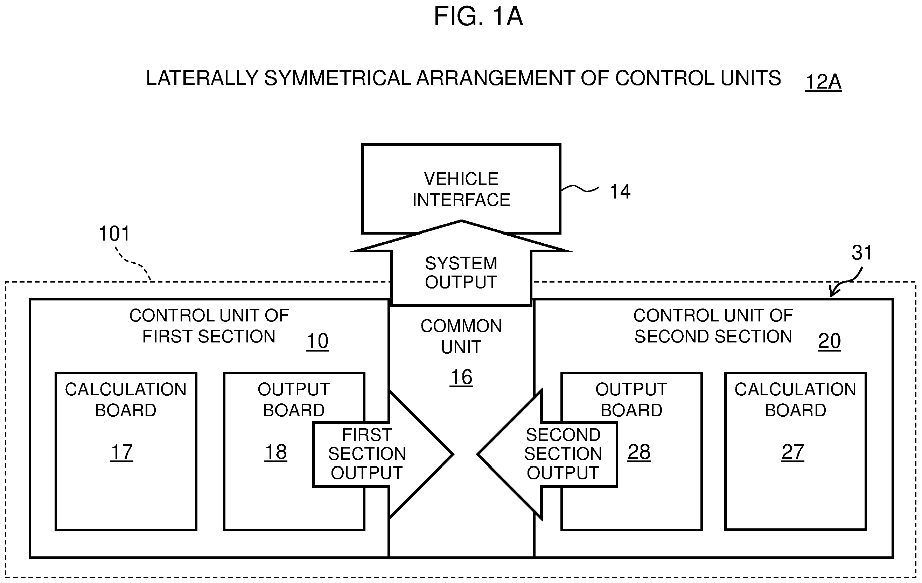

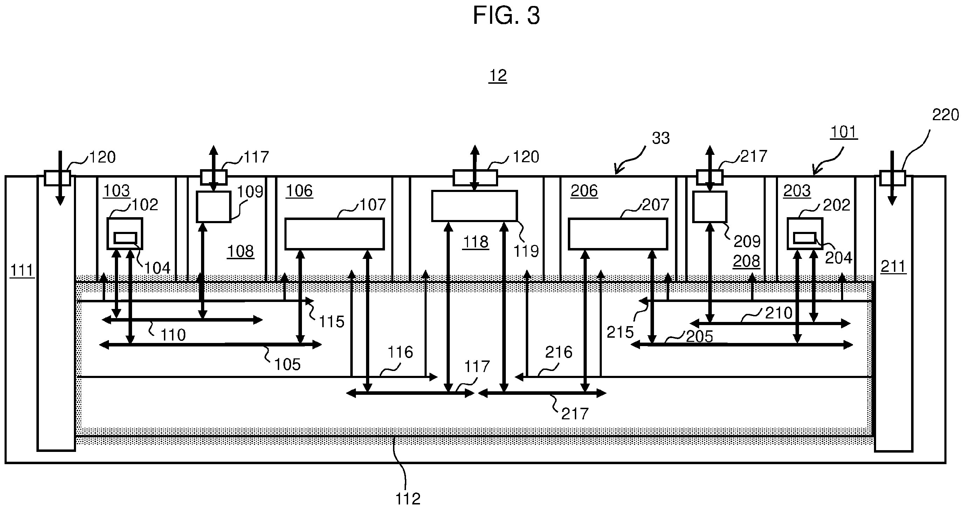

Terms necessary for a description of the present embodiment will be defined. Here, a sub-rack accommodating electronic circuits constituting an on-vehicle control device is an accommodating tool of printed boards (PCBs, hereinafter also referred to as "circuit boards" or simply "boards") directed to a standard, and generally refers to a metal housing or frame. This accommodating tool is referred to as a card cage, a housing, a case, a cabinet, a chassis, or simply a rack in addition to a sub-rack 101 shown in FIGS. 3, 4, and 7 to 10. Aggregates 31 to 35 (collectively 30) shown in FIGS. 1A to 4 and FIGS. 8 to 10 are the electronic circuits constituting the on-vehicle control device, and refer to all of the electronic circuits accommodated in the accommodating tool such as the sub-rack 101.

A definition relating to dimensions of main components in a computer usage environment is referred to as a form factor. The form factor includes definitions, for example, a 19-inch system standard, a 19-inch euroboard form factor, or a 19-inch plug-in unit (PIUs).

In a case of the 19-inch system standard, a 19-inch standard (EIA standard) is adopted as dimensions of the rack and the chassis in order to standardize the chassis that accommodates the circuit boards. As a method of mounting the circuit boards on the 19-inch standard chassis, the following criteria (1) to (3) are set. Accordingly, the sub-rack 101 that accommodates an on-vehicle control system is directed to the following criteria (1) to (3) in principle, even if the sub-rack 101 does not have the 19-inch standard.
(1) Dimensions of the circuit boards are unified.
(2) Since mutual connection of the circuit boards is performed by a backboard, types of connectors forming a coupling mechanism are unified.
(3) For heat dissipation, the circuit boards are disposed vertically.

A backboard 112 shown in FIGS. 3, 4, and 7 to 10 is one type of the circuit boards (usually, printed board), and a plurality of connectors are correctly connected to each other (corresponding pins of each connector are connected to each other) on the board to form a bus. That is, the backboard 112 interconnects a plurality of circuit boards into which the connectors are inserted, and functions as a backbone constituting a computer system. In FIGS. 3, 4, and 7 to 10, the connectors for connecting the plurality of circuit boards to the backboard 112 are not shown.

Unlike a motherboard, the backboard 112 has no calculation capability on the circuit board thereof, and a CPU is on a CPU board provided by a plug-in manner. Although cables may be used to connect the circuit boards to each other, the backboard is generally used to connect the circuit boards to each other from a viewpoint of reliability, workability, and a bus configuration.

### [On-Vehicle Control Device]

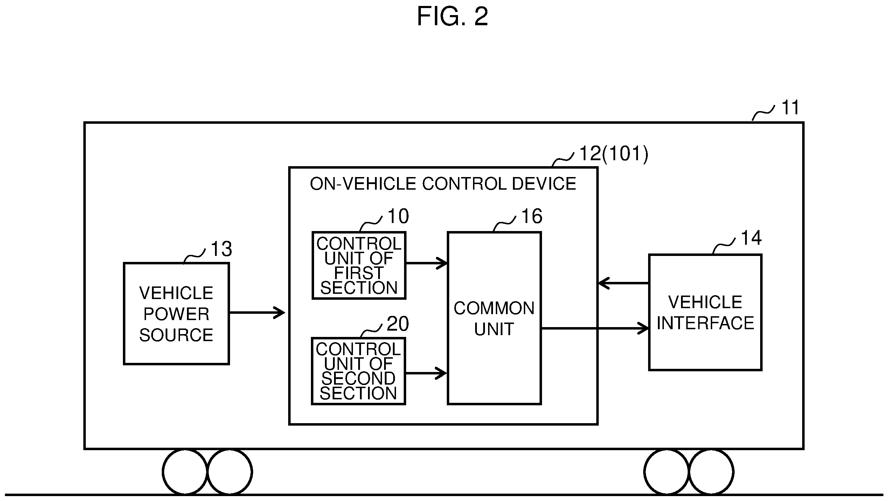

An on-vehicle control device 12 (FIG. 2) for a railway vehicle is generally configured in, as a form constituting a system, units of a group of boards on which electronic circuits are mounted and the sub-rack 101 (FIGS. 3, 4 and 7 to 10) that accommodates the group of boards. In this case, the electronic circuits on the board, signal lines connecting elements, an internal power source used for a bus and the like, and an external power source used for an interface to a vehicle and other devices are clearly distinguished from each other. In general, it is important to distinguish that a low voltage is applied to the internal power source used in an electronic circuit and a high voltage is applied to a power source for driving the vehicle or an external power source used for a lead line between vehicles.

In addition to a difference in voltage, it is important to distinguish the internal and external power sources from each other in terms of avoiding noise. The external power source may receive noise from a high-voltage power source circuit used in other devices such as a vehicle and a main conversion device. When the noise is drawn into the sub-rack 101 from the external power source, the on-vehicle control device 12 may malfunction. Similarly, the noise may be diffused from an internal circuit of the on-vehicle control device 12 via a signal line to the outside, thereby affecting other devices.

Therefore, it is required to clearly distinguish the internal power source and the external power source of the sub-rack 101, for example, by electrically insulating input and output signals of the on-vehicle control device 12 via a relay or the like. Among the input and output signals handled by the on-vehicle control device 12, a signal transmitted by electrical ON/OFF or Hi/Low has suitable operation characteristics of the relay.

Further, the on-vehicle control device 12 may be a redundant system because it is necessary to improve reliability. The redundant system is configured as a multiplex section in which a minimum unit constituting a control unit is set as a section, and even if one section fails, other sections can continuously execute control. The redundant system having such a multiple-section configuration can continue an operation of the entire system even if a part of the system failure, and can improve the reliability of the system.

The multiple-section configuration of the on-vehicle control device 12 may be roughly divided into two types of redundant configurations in which a section-to-section matching logic is used to perform a matching output. The first type is a redundant configuration in which a plurality of sections simultaneously operate to perform control. The second type is a redundant configuration in which there is one normally operating section, and a standby section takes over and continues to operate when a failure occurs in the operating section.

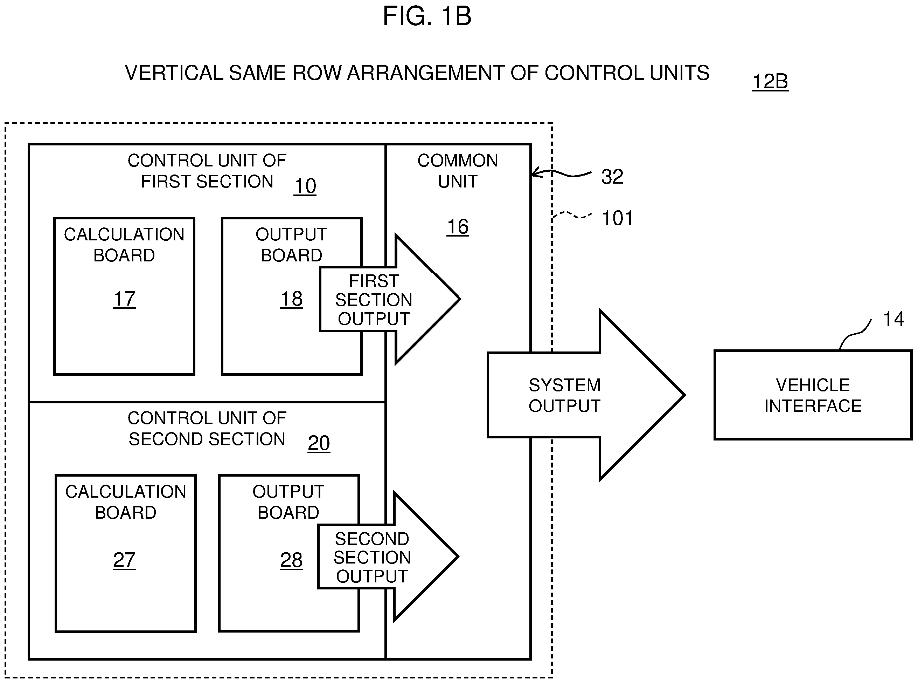

Meanwhile, when the on-vehicle control device 12 is viewed from an external device via an external input and output device connected to the on-vehicle control device 12 or a vehicle interface 14 (FIGS. 1A, 1B, and 2), it is desired to eliminate extra consideration for a fact that the on-vehicle control device 12 is multiplexed. That is, for the external device, it is desirable that the on-vehicle control device 12 has the same interface as a single section even if the on-vehicle control device 12 is multiplexed.

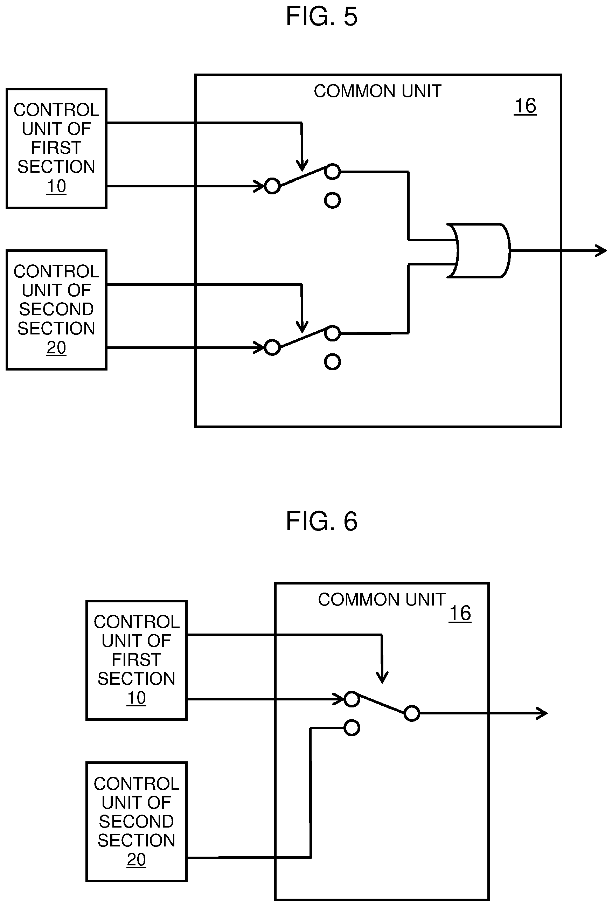

In this regard, as will be described later with reference to FIGS. 5 and 6, the on-vehicle control device 12 constituting the multiple section includes a common unit 16 for a matching output to the outside with respect to an external interface in accordance with logics requested to be output from the respective sections of control units 10 and 20 and the section-to-section matching logic. The on-vehicle control device 12 is accommodated in the dedicated sub-rack 101 in consideration of the common unit enlarged according to a scale of a logic circuit, a size of a single element such as a relay, and a restriction on an accommodating volume.

In this way, the on-vehicle control device 12 solves a problem that it is difficult to mount the on-vehicle control device 12 due to an increase in a size of the entire device including the external input and output device connected to the on-vehicle control device 12 and the vehicle interface 14. In addition, the on-vehicle control device 12 eliminates a disadvantage that a cable in an accommodating tool of the related art becomes large in size. That is, the on-vehicle control device 12 also eliminates complicated cables that are interposed in order to transfer signals across a plurality of sub-racks in the accommodating tool of the related art.

From these viewpoints, as will be described later with reference to FIGS. 1A, 1B, and 2, the on-vehicle control device 12 (also including on-vehicle control devices 12A to 12E) can reduce a total cost of the on-vehicle control device 12 including accessory devices. In this way, in order to make the multiple-section configuration compact, the on-vehicle control device 12 solves a problem that the entire device including the accessory devices is accommodated in one sub-rack 101 (FIGS. 3, 4, and 7 to 10) and the number of large-scale cables is reduced. Therefore, the following is studied.

First, a size of the common unit is reduced as sizes of the elements are reduced. Accordingly, the arrangement is changed such that the common unit, which is positioned outside a board as an accessory device in the related art, is also disposed inside the board. Accordingly, in addition to the boards of the respective sections constituting the plurality of control units 10 and 20, all the boards mounted up to the common unit 16 are accommodated as the aggregates 31 and 32 in one sub-rack 101.

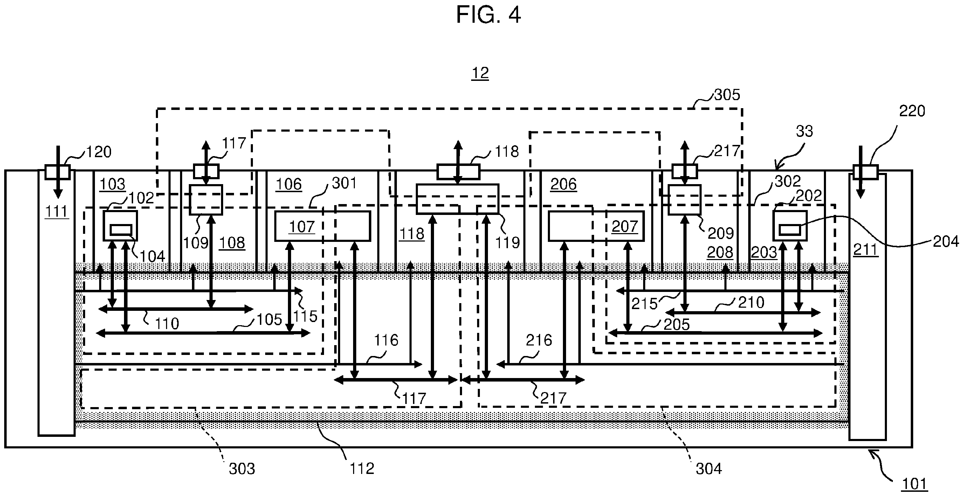

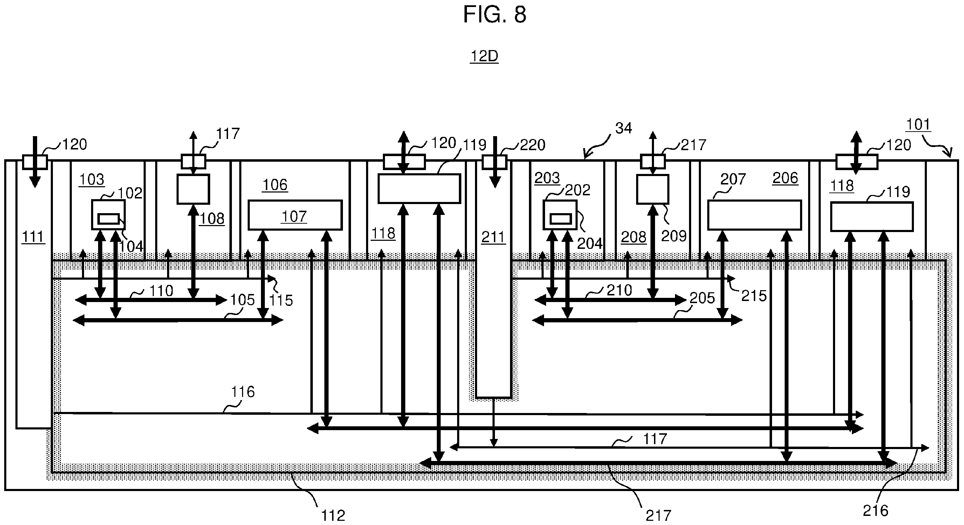

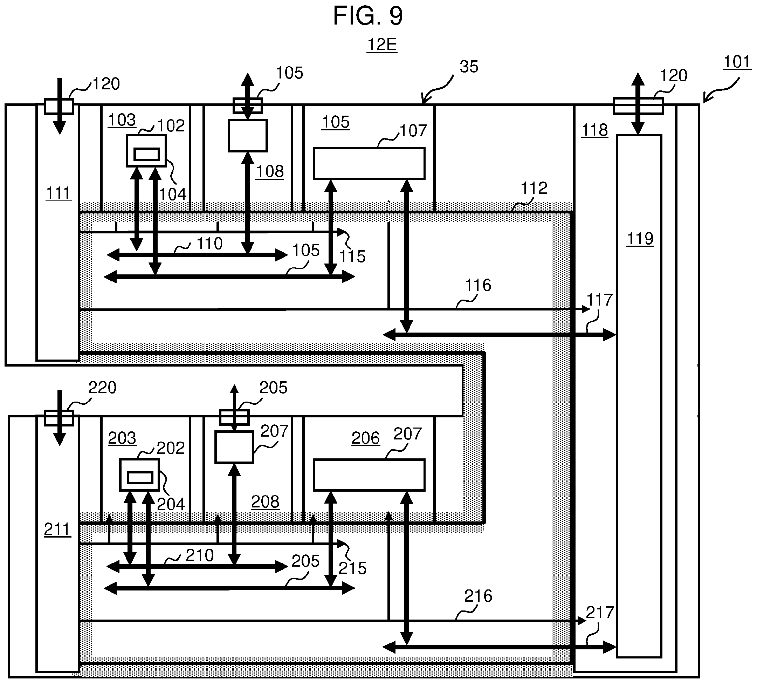

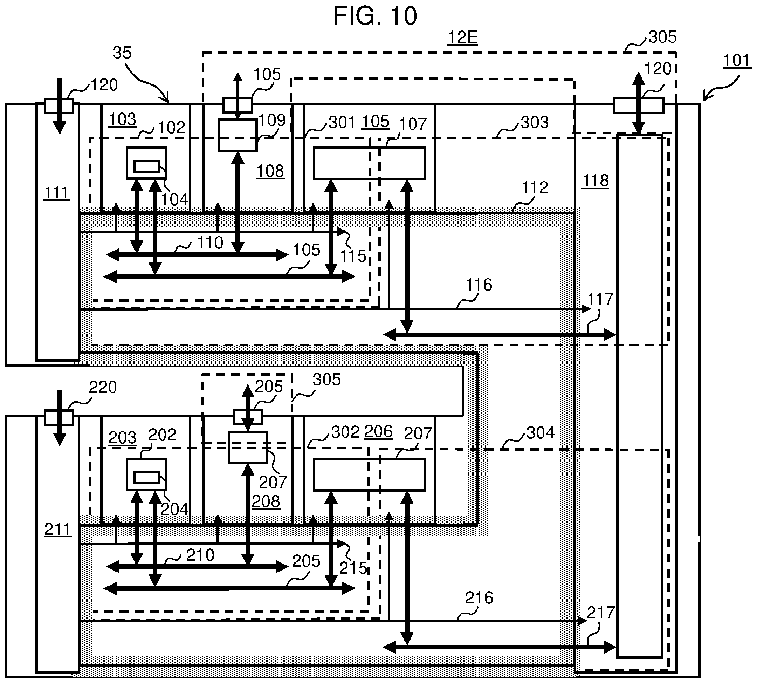

Regarding the aggregates 31 and 32, the aggregate 31 of FIG. 1A, the aggregate 32 of FIG. 1B, the aggregate 33 of FIGS. 3 and 4, the aggregate 34 of FIG. 8, and the aggregate 35 of FIGS. 9 and 10 are collectively referred to as the aggregate 30, and a form in which any one of the aggregate 30 is accommodated in one sub-rack 101 is shown.

### [Embodiment]

Hereinafter, an on-vehicle control system according to an embodiment of the invention will be described in detail in the order of the respective drawings. FIG. 1A is a block diagram showing a board arrangement of the on-vehicle control device 12A according to the embodiment of the invention, and is a laterally symmetrical arrangement example. As shown in FIG. 1A, elements of the on-vehicle control device 12 are disposed such that boards of respective sections of a control unit of a first section and a control unit of a second section are disposed in a laterally symmetrical manner, and the common unit 16 (FIG. 2) is disposed at a center, thereby forming the aggregate 31.

FIG. 1B is a block diagram showing the on-vehicle control device 12B according to a modification of FIG. 1A, and is a vertically symmetrical (vertically aligned) arrangement example. As shown in FIG. 1B, the control units 10 and 20 of the first and second sections are disposed in the same vertical array, and the common unit 16 (FIG. 2) is disposed at an end of the sub-rack 101 so as to be adjacent to the control units 10 and 20, thereby forming the aggregate 32.

The on-vehicle control system is configured to be accommodated in the sub-rack 101, and includes the control unit 10 of the first section, the control unit 20 of the second section, and the common unit 16 (FIG. 2). Each of the control units 10 and 20 constituting the two sections includes a calculation board that performs calculation and an output board that outputs a calculation result. The common unit 16 outputs, to the vehicle interface 14, a system output obtained by combining calculation outputs from the respective sections in the redundant system into one according to a logic required by the system. As a result, a redundant system is configured, and reliability of the entire system is improved.

As shown in FIGS. 1A and 1B, the on-vehicle control device 12 includes the common unit 16 at one position in the sub-rack 101, and in FIG. 1A, the boards of the respective sections constituting the two control units 10 and 20 are disposed in a laterally symmetrical manner, and the common unit 16 is disposed at the center. In FIG. 1B, the boards of the respective sections constituting the two control units 10 and 20 are disposed in the same vertical array, and the common unit 16 is disposed at an end portion of the sub-rack 101 so as to be adjacent to the respective sections of the control units 10 and 20.

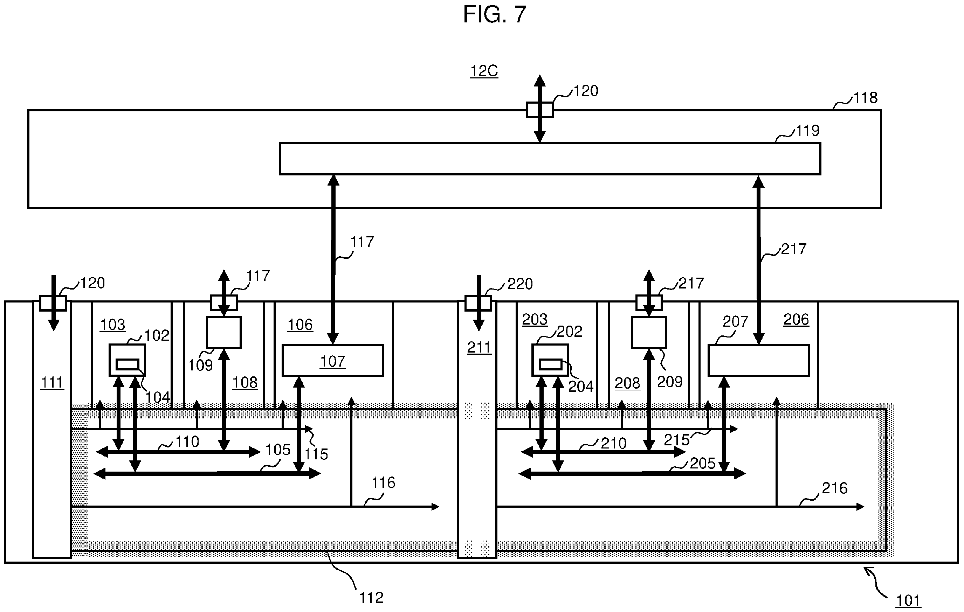

FIG. 2 is a schematic explanatory diagram of an arrangement example in which the on-vehicle control device 12 generalized for explanation is disposed on a vehicle. The on-vehicle control device 12 in FIG. 2 collectively refers to the on-vehicle control device 12A in FIG. 1A, the on-vehicle control device 12B in FIG. 1B, the on-vehicle control device 12 in FIGS. 3 and 4, the on-vehicle control device 12C in FIG. 7, the on-vehicle control device 12D in FIG. 8, and the on-vehicle control device 12E in FIGS. 9 and 10.

As shown in FIG. 2, a train 11 includes the on-vehicle control device 12, a vehicle power source 13, and the vehicle interface 14. The on-vehicle control device 12 has a function of performing speed inspection based on an external signal and a vehicle speed. The vehicle power source 13 supplies power to each device mounted on the train 11.

The vehicle interface 14 has a function of transmitting an output signal from the on-vehicle control device 12 to a vehicle forming the train 11 and also transmitting information on the vehicle to the on-vehicle control device 12 as an input signal.

Here, the on-vehicle control device 12 includes the control units 10 and 20 that perform fail-safe calculation, and the common unit 16 that transmits outputs from the control units 10 and 20 to the outside. The control units 10 and 20 include one or a plurality of sections depending on a device configuration, and the common unit 16 outputs the outputs from the control units 10 and 20 of respective sections to the vehicle interface 14 according to an output logic required in the system configuration.

FIG. 3 is a block diagram showing the on-vehicle control device 12 of FIG. 2 in more detail. As shown in FIG. 3, the on-vehicle control device 12 in which the aggregate 33 is accommodated in the sub-rack 101 forms the aggregate 33 centering on fail-safe calculation boards 103 and 203 on which fail-safe calculation units 102 and 202 that perform calculation processing with high safety are mounted. The fail-safe calculation units 102 and 202 include failure detection circuits 104 and 204 capable of detecting a system failure including a failure of the calculation unit itself and outputting a failure detection signal.

In the sub-rack 101, functional units of the fail-safe calculation boards 103 and 203 to execute input and output with the outside are mounted. Dedicated buses 105 and 205 are used for an output section for ensuring safety, and are connected to safety output boards 106 and 206 by a multiple configuration for maintaining a fail-safe performance. The safety output boards 106 and 206 include output circuits 107 and 207 for receiving output signals from the fail-safe calculation boards 103 and 203 and outputting the output signals to the outside.

General-purpose input and output boards 108 and 208 include transmission and reception circuits 109 and 209, are connected to the fail-safe calculation units 102 and 202 via general-purpose buses 110 and 210, and perform the input and output to and from the outside in accordance with instructions from the fail-safe calculation units 102 and 202. In order to increase the number of interfaces with the outside, an input and output board may be added by extending the general-purpose buses 110 and 210. Further, boards connected to the general-purpose buses 110 and 210 are not limited to the input and output, and may be boards on which memories, sensors, or the like are mounted.

At this time, in order to ensure safety, a section of the safe-fail dedicated buses 105 and 205 and a section of the general-purpose buses 110 and 210 used for a fail-safe output are separated from each other. The sub-rack 101 includes power source boards 111 and 211 that convert an input power source from the outside and distribute the input power source to the respective boards inside the device. Signals between the respective boards and the respective power source boards are connected via the backboard 112.

With a configuration shown in FIG. 3, a system unit of the on-vehicle control device 12 is configured. At this time, a minimum unit constituting the system is referred to as a section. As a premise, the safety of the system is ensured by a single section. For a purpose of improving an operating rate of the system, a redundant section (multi-section system) using a plurality of the same systems is configured in order to configure the redundant system.

Usually, a device outside the system exemplified by the vehicle interface 14 or the like does not include an interface suitable for the multiple-section configuration of the on-vehicle control device 12. Therefore, outputs of the plurality of sections in the multi-section system (redundant system) are outputted to the outside after being unitized into the system output adapted to a system request.

For example, when any one of multiple sections instructs a brake output, the entire system transmits the brake output to the outside. Further, for example, in a case in which one section is the operating section and the other section is the standby section, an output of a section other than the operating section to the outside may be cut off. These logics are configured with a relay circuit 119 using a relay so as to exhibit the fail-safe performance in which a control output is switched to a safe side when a failure or the like occurs. The relay circuit 119 is mounted on the above-described common unit 16 (FIGS. 1A, 1B, and 2).

The on-vehicle control device 12 outputs a fail-safe output to the outside from the safety output boards 106 and 206, and has a circuit for connecting a safety output and a signal line to the outside of the system in order to distinguish a power source inside the on-vehicle control device 12 from a power source used in the circuit to be mounted on the vehicle and to perform the section-to-section matching logic. This circuit is mainly implemented by the relay, and is referred to as the common unit 16 because the common unit 16 is commonly used for the outputs of the control unit 10 of the first section and the control unit 20 of the second section.

In the safety output boards 106 and 206, in the 106 and 206, circuits used for buses from the fail-safe calculation units 102 and 202 and circuits to the common unit 16 are distinguished from each other. The fail-safe calculation units 102 and 202 output signals indicating operation states to the outside. When the fail-safe calculation units 102 and 202 detect a failure of the fail-safe calculation units 102 and 202 or the system, the fail-safe calculation units 102 and 202 output failure information to the inside and outside of the system.

A power source at this time is divided into power sources 115 and 215 used for a section of the bus 105 and a section of the bus 110, and a section of the bus 205 and a section of the bus 210, and power sources 116 and 216 used between a safety board and the common unit 16. A signal is input to the relay circuit 119 in a common unit 118 via the buses and output to the outside.

At this time, an internal power source and an external power source are electrically insulated from each other by the relay in the relay circuit 119. The output to the outside is performed on a front side of the sub-rack 101, and a power source input is performed in connectors 117 and 217 or a connector 120, and the output can be performed at positions other than the front as long as the output and input do not interfere with the configuration of sub-rack 101.

In the system configuration of the on-vehicle control device 12, a restriction condition of a board arrangement in the sub-rack 101 changes depending on whether a sufficient area for developing a circuit pattern is ensured in the backboard 112. When the development area of the circuit pattern is sufficient, there is no restriction, and when the development area is not insufficient, there is a restriction. Meanwhile, in order to achieve miniaturization and function integration of the device, the backboard 112 is also required to increase the number of wirings and reduce an area of the backboard 112.

Here, different power sources are used for a power source used for elements such as an internal electronic circuit and a power source used for an external output. In this case, when wirings of the external and internal power sources divisions are mixed, and the external and internal power sources may be affected by the noise included in the respective power sources. Therefore, when the board is disposed as shown in FIG. 3 and a pattern of the backboard 112 is formed, the external and internal power source divisions can be clearly distinguished from each other. As a result, the on-vehicle control device 12 can prevent an adverse effect that the internal and external noise interferes with each other.

FIG. 4 is a block diagram showing an efficient arrangement of the on-vehicle control device 12 in FIG. 2 in the sub-rack. FIG. 4 shows the board arrangement and the power source divisions of the sub-rack 101. The aggregate 33 accommodated in one sub-rack 101 includes the power source board 111, the fail-safe calculation board 103, the general-purpose input and output boards 108 and 208, the safety output boards 106 and 206, and the common unit 16. In this case, the power source in the sub-rack 101 is divided into three divisions.

A first division is internal power sources 301 and 302. A second section is common unit output power sources 303 and 304. A third section is an external power source 305. The internal power sources 301 and 302 are used for the fail-safe calculation boards 103 and 203, the general-purpose input and output boards 108 and 208, and the safety output boards 106 and 206.

The common unit output power sources 303 and 304 supply power to both the safety output boards 106 and 206 and the common unit 16 (see FIGS. 1A, 1B, and 2).

Further, the external power source 305 is electrically insulated from the common unit output power sources 303 and 304 in the common unit 16. Accordingly, the external power source 305 and the internal power sources 301 and 302 are separated from each other, and wiring regions of the internal power sources 301 and 302 and the common unit output power sources 303 and 304 are separated from each other on the backboard 112, thereby preventing an influence of the noise on each other. The external power source 305 is input to the general-purpose input and output boards 108 and 208, and is insulated from the internal power sources 301 and 302 on the board.

FIG. 5 is a block diagram showing an interface configuration of each section and the common unit in the on-vehicle control device 12 of FIG. 3, and is an example of a system in which double sections operate in parallel. In the on-vehicle control device 12 of FIG. 5, the redundant system always operates in parallel, and either one of the outputs of the redundant system is system-outputted to the outside by the relay at a last stage. The common unit is configured to operate in accordance with the output logic required for the system.

FIG. 6 is a block diagram showing an interface configuration in which one of the double sections is set as a main section and the other is set as a spare standby section with respect to the configuration of FIG. 5. That is, in the on-vehicle control device 12 of FIG. 6, one side normally operates as the main section, and when the operating main section fails, the control shifts to the standby section. In order to implement this configuration, an output of a sub-section is prevented when the main section is normal, and an output of the main section is prevented when the main section fails.

This logic is configured with failure detection outputs from the fail-safe calculation units 102 and 202 of the respective sections. These logics are implemented only by the common unit. That is, by replacing the common unit according to the system, it is possible to switch the logic without changing the other boards or the backboard 112.

When one section fails, it is necessary to transmit information indicating that the section fails to the external device and to separate the failed section from the control. Therefore, the common unit acquires the failure information from each section in addition to the output from each section. It is also possible to add a board on which an additional function such as serial communication or a digital input is mounted in the control units 10 and 20.

Also in a fail-safe board and other input and output boards, an interface or the like capable of performing section determination externally based on contents of an application or a telegraphic message, such as Ethernet or serial transmission, may be implemented. In this case, it is not necessary to combine these signal lines by a relay logic.

In an existing double section configuration, the common unit is disposed outside the control units 10 and 20 in a form of the sub-rack 101 or a relay board. In this form, the output from the output board is outputted to the common unit 118 via the connector 120.

FIG. 7 is a block diagram showing an arrangement example of the on-vehicle control device 12C in which the double sections are integrated into one sub-rack and the common unit is configured with one sub-rack. In the on-vehicle control device 12C shown in FIG. 7, since the common unit 118 is disposed outside because a large relay is used, a cable is necessary for exchanging signals between the control units 10 and 20 and the common unit. Therefore, a size of a device configuration of the system is increased, leading to an increase in a cost of the overall hardware configuration. In addition, since data exchange is performed between the devices by the cable, the devices are easily affected by external noise.

FIG. 8 is a block diagram showing an arrangement example of the on-vehicle control device 12D in which the common unit is incorporated and the double sections are configured in the same arrangement. The on-vehicle control device 12D shown in FIG. 8 is configured such that the aggregate 34 is accommodated in one sub-rack 101. The aggregate 34 constituting the on-vehicle control device 12D can be disposed inside the board by using a small relay. By incorporating the common unit 118, the output board transmits the output signal to the common unit via the backboard 112.

In this arrangement, although backboard patterns of the respective sections in a basic bus relationship can be made the same, the number of wirings extending over the respective sections increases because the wirings are provided to the common unit. Accordingly, the backboard patterns become complicated, and there is a risk that the signal lines inside the sub-rack 101 are affected by the noise. The backboard pattern refers to a wiring pattern of the backboard formed on the printed board.

The configuration in which the double sections of the on-vehicle device 12 according to the embodiment of the invention described above with reference to FIG. 3 are disposed in a laterally symmetrical manner has been shown. The section configured with the left system is referred to as the control unit 10 of the first section, and the section configured with the right system is referred to as the control unit 20 of the second section. Here, the common unit is mounted in the same sub-rack 101 as the control units 10 and 20. Each section is configured with the board arrangement described above, and the common unit is disposed at the center, leading to each section being disposed in a laterally symmetrical manner. The respective sections have a common structure except that the sections are disposed in a laterally symmetrical manner.

Similarly, the patterns on the backboard 112 has a laterally symmetrical structure. The left and right sections have individual power sources, and the power source sections are divided on the backboard 112. Further, the buses of the left and right sections do not intersect with each other, and thus are not affected by each other. An external interface board such as a serial board can be added, and the output board and the common unit are adjacent to each other such that the external interface and the internal bus do not intersect with each other.

As for the power source divisions of the backboard 112, there are power source divisions on the backboard 112. Since the two power source divisions affect each other, it is necessary to divide the power source divisions. By separating the dedicated bus section (bus line) and the bus section close to the external output, the mutual influence can be prevented.

At this time, by providing the boards in the sections in a laterally symmetrical manner, it is possible to separate an external line and an internal line in the backboard 112. When the number of input and output boards is increased, the number of boards can be increased without changing the configuration of the backboard 112 by extending the internal line and the external line.

In this way, by using the board arrangement and the power source divisions on the backboard 112 described above and arranging both sections in a laterally symmetrical manner and arranging the common unit at the center, the signals from the respective sections can be simply aggregated in the common unit, and in addition, it is possible to implement a configuration that is not easily affected by the noise and it is possible to reduce the number of wirings of the backboard 112 and the external wirings straddling between the sections.

FIG. 9 is a block diagram showing an arrangement example of the on-vehicle control device 12E in which the double sections of FIG. 8 are set to be vertically symmetrical. The on-vehicle control device 12E shown in FIG. 9 is configured such that the aggregate 35 is accommodated in one sub-rack 101. The aggregate 35 forming the on-vehicle control device 12E is disposed vertically symmetrically, and thus the common unit is disposed at one end of the same side of each of the double sections.

In this case, the common unit is configured to receive the boards of the respective sections and to be able to receive the wiring of the backboard 112 of the upper and lower sections in order to match information inside the boards. In FIG. 9, the board configuration straddling vertically is configured, and individual relay boards may be used in the upper and lower sections as long as the signals can be transmitted and received in the backboard 112.

FIG. 10 is a block diagram showing an arrangement example in which the power source divisions of the backboard of the on-vehicle control device 12E of FIG. 9 are efficiently applied. As shown in FIG. 10, the same effect as in the case of lateral symmetry can be obtained even when the arrangement of the two sections in the on-vehicle control device 12 according to the embodiment of the invention is vertically symmetrical. That is, the on-vehicle control device 12 can simplify the wiring and can reduce the influence of the noise by dividing each wiring line between the inside and the outside of the sub-rack 101.

Further, according to the double section arrangement of the on-vehicle control device 12 shown in FIG. 10, the following effects can be obtained. That is, in the on-vehicle control device 12 of FIG. 10, unlike the double section arrangement of the on-vehicle control device 12 shown in FIG. 2, the backboard 112 having the same pattern configuration can be adapted to each of the upper and lower sections. As a result, it is possible to contribute to commonalization and standardization of components and to reduce the cost.

The on-vehicle control device 12 according to the embodiment of the invention can be summarized as follows.
[1] In the on-vehicle control device 12, the control units 10 and 20 of the multiple sections forming the redundant section include the fail-safe calculation units 102 and 202 that complement each other by the respective calculation results thereof. The control units 10 and 20 in which the fail-safe calculation units 102 and 202 are disposed include calculation boards 17 and 27, output boards 18 and 28, and the common unit 16.

The calculation boards 17 and 27 perform calculation processing for the sections, respectively. The output boards 18 and 28 output respective calculation results of the calculation boards 17 and 27. The common unit 16 includes the common interface connected to the plurality of output boards 18 and 28. The output boards 18 and 28 output the calculation results generated therein to the outside via the common interface.

The fail-safe calculation units 102 and 202 are configured in the collective aggregate 30, and are disposed such that the common unit 16 is aggregated in a partial specific region in the aggregate 30. In the aggregate 30, the control units 10 and 20 of the multiple sections aggregate the interfaces with the common unit 16 at one end in the board arrangement. For example, when the common unit 16 is disposed between the control unit 10 and the control unit 20, the control unit 10 and the control unit 20 are disposed in the laterally symmetrical manner, and the interfaces with the common unit 16 are also disposed at the center. In this case, a shortest distance is sufficient for the wirings from the common unit 16 located at the center to the control units 10 and 20, and a frequency of crossing over different wirings can also be reduced.

The aggregate 30 collectively refers to the various aggregates 31 to 35 shown in the drawings. That is, the aggregate 30 is a generic term for the aggregate 31 in FIG. 1A, the aggregate 32 in FIG. 1B, the aggregate 33 in FIGS. 3 and 4, the aggregate 34 in FIG. 8, and the aggregate 35 in FIGS. 9 and 10. That is, the aggregates 31 to 35 (collectively 30) shown in FIGS. 1A to 4 and FIGS. 8 to 10 are electronic circuits constituting the on-vehicle control device 12, and refer to all components accommodated in the accommodating tool such as the sub-rack 101.

The on-vehicle control device 12 in FIG. 2 collectively refers to the on-vehicle control device 12A in FIG. 1A, the on-vehicle control device 12B in FIG. 1B, the on-vehicle control device 12 in FIGS. 3 and 4, the on-vehicle control device 12C in FIG. 7, the on-vehicle control device 12D in FIG. 8, and the on-vehicle control device 12E in FIGS. 9 and 10. The on-vehicle control device 12 of a form different from that of FIG. 2 is formed by accommodating different aggregates 30 in one sub-rack 101.

By the arrangement of the on-vehicle control device 12, the common interface can be aggregated at a certain position of the aggregate 30. As a result, the multiple-section configuration of the on-vehicle control device 12 can be made compact.

That is, when the common units 16 are respectively provided in the control units 10 and 20 having the multiple-section configurations (for example, the double section configurations) having the same function, a power source, an input and output terminal, and the like are required in each of the control units 10 and 20. To the contrary, consolidating the common unit 16 into one section is advantageous because spaces and resources can be saved.

For example, due to a configuration in which two sections are disposed in a laterally symmetrical manner from the common unit 16, in the on-vehicle control device of the related art, the two sections are discretely provided in a plurality of sub-racks (housings) and the cables of a large scale are connected thereto. To the contrary, as shown in FIGS. 1A, 3, 4, and 8, in the on-vehicle control device 12 according to the embodiment of the invention, the collective aggregate 30 is formed and can be accommodated in one sub-rack (housing) 10.

In the on-vehicle control device 12, the redundant sections constituting the fail-safe calculation units 102 and 202 are integrated into the collective aggregate 30. Accordingly, the control units 10 and 20 of the multiple sections and the common unit 16 coexist in the aggregate 30. The control units 10 and 20 of the multiple sections are disposed such that the position of the common interface is aggregated at one end of each of the control units 10 and 20. Accordingly, the output signals can be aggregated in the common unit 16 by a simple wiring. More details are as exemplified below.

Although the control units 10 and 20 include a plurality of circuits and signals in the device, the two sets have the same configuration in the board arrangement and the circuit configuration. In addition, the interfaces with the common unit are disposed at one end such that the outputs to the common unit 16 can be efficiently aggregated. Accordingly, in FIG. 1A, the control units are disposed (line-) symmetrically with respect to the common unit 16. Although the control units 10 and 20 are not (line-) symmetrically with respect to the common unit 16 in FIG. 1B, the interfaces to the common unit 16 are integrated at one end of the control units 10 and 20, and the same effect as in FIG. 1A can be obtained.

[2] In the on-vehicle control device 12, the aggregate 30 is accommodated in one housing (sub-rack) 101. The aggregate 30 includes the backboard 112, and a plurality of circuit boards 103 and 203 that are electrically connected to the backboard 112 via a coupling mechanism such as a connector and can be detachably fitted one by one. Accordingly, only one circuit board in which a failure is found can be replaced with a non-defective product, and a function of the entire on-vehicle control device 12 can be quickly recovered.

The backboard 112 is fixed to a back portion of the housing (sub-rack) 101, allows the circuit boards 103 and 203 to be detachably fitted via the coupling mechanism such as the connector, and connects the power source and the signal. In order to connect the power source and the signal, the general-purpose buses 110 and 210 and the fail-safe dedicated buses 105 and 205 are disposed on the backboard 112.

As the circuit boards 103 and 203, the fail-safe calculation boards 103 and 203 are representatively exemplified from among many types. In addition, the failure detection circuits 104 and 204, the safety output boards 106 and 206, the output circuits 107 and 207, the general-purpose input and output boards 108 and 208, the transmission and reception circuits 109 and 209, and the power source boards 111 and 211 can be listed.

[3] The sub-rack 101 is suitable as the housing 101 that accommodates the on-vehicle control device 12.

[4] The on-vehicle control device 12 may include two control units 10 and 20 having the same configuration, that is, the control unit 10 of the first section and the control unit 20 of the second section, in one sub-rack 101. In the on-vehicle control device 12, the fail-safe calculation units 102 and 202 of the double sections, in which when one of the first section and the second section fails, a calculation result of the other section is used for control, are constituted.

The on-vehicle control device 12 includes a common interface for connecting the calculation results generated by control boards 10 and 20 of the control unit 10 of the first section and the control unit 20 of the second section to the outside. The common interface is mounted at one position of the aggregate 30.

These two control units 10 and 20 include the dedicated calculation boards 17 and 27 and the output boards 18 and 28, respectively. That is, the calculation board 17 and the output board 18 are disposed in the control unit 10 of the first section. Similarly, the calculation board 27 and the output board 28 are disposed in the control unit 20 of the second section.

That is, the output boards 18 and 28 that independently output the calculation results are connected to the calculation boards 17 and 27 of the two sections, respectively. The calculation result is connected to the outside from the common interface mounted at one position of the aggregate 30.

According to the invention, in the on-vehicle control device 12 including the fail-safe calculation units 102 and 202 of the double sections, the control units 10 and 20 and the common interface coexist in the sub-rack 101. The common interface is integrated into the common unit 16 provided at one position of the aggregate 30. As a result, the output signal can be connected to the outside with a simpler wiring.

[5] In the on-vehicle control device 12, the calculation board 17 and the output board 18 constituting the control unit 10 of the first section and the calculation board 27 and the output board 28 constituting the control unit 20 of the second section may be disposed in the laterally symmetrical manner in the sub-rack 101. In this case, the common unit 16 including the common interface is preferably disposed between the control unit 10 of the first section and the control unit 20 of the second section.

The term "(line-) symmetrically" shown in FIG. 1A refers to an arrangement that matches when folded (along a virtual center line in the figure) . The control units 10 and 20 disposed (line-) symmetrically are equidistant from the common unit 16 including the center line. Therefore, the output boards 18 and 28 are disposed near the common interface positioned near the center of lateral symmetry. As a result, the output signal can be connected to the outside with the simpler wiring. In addition, in the arrangement shown in FIG. 1B, the control units 10 and 20 are equidistant from the common unit 16. In this case, although the arrangement is not line-symmetric, an operation and effect similar to those of the arrangement shown in FIG. 1A can be obtained.

[6] In the on-vehicle control device 12, the calculation board 17 and the output board 18 constituting the control unit 10 of the first section and the calculation board 27 and the output board 28 constituting the control unit 20 of the second section may be vertically disposed in the same array in the sub-rack 101. In this case, it is preferable that the common interface is disposed at an end portion of the sub-rack 101 so as to be close to the control unit 10 of the first section and the control unit 20 of the second section at an equal distance and to be directly connected to the respective output boards 18 and 28. As a result, the output signal can be connected to the outside with the simpler wiring.

### Reference Signs List

10 control unit (of first section)
11 train
12A to 12E (collectively 12) on-vehicle control device
13 vehicle power source
14 vehicle interface
15 control unit
16 common unit
17, 27 calculation board
18, 28 output board
20 control unit (of second section)
31 to 35 (collectively 30) aggregate
101 sub-rack
102, 202 fail-safe calculation unit
103, 203 fail-safe calculation board
104, 204 failure detection circuit
106, 206 safety output board
107, 207 output circuit
108, 208 general-purpose input and output board
109, 209 transmission and reception circuit
111, 211 power source board
112 backboard
105, 110, 205, 210 bus (section)
105, 205 (fail-safe) dedicated bus (section)
110, 210 general-purpose bus (section)
115, 116, 215, 216 power source
117, 120, 217 connector
118 common unit (relay board)
119 relay circuit
301, 302 internal power source
303, 304 common unit output power source
305 external power source

## Claims

1. An on-vehicle control device in which each of control units of multiple sections forming a redundant section includes a fail-safe calculation unit, wherein
the control units in which the fail-safe calculation units are disposed are configured as a collective aggregate,
the on-vehicle control device comprising:
calculation boards configured to perform calculation processing for the multiple sections, respectively; and
output boards configured to output a calculation result of the calculation processing performed by the calculation boards, and
a common unit including a common interface connected to the plurality of output boards respectively corresponding to the multiple sections is aggregated in a partial specific region of the aggregate.

2. The on-vehicle control device according to claim 1, wherein
the control units of the multiple sections are disposed in one housing,
the on-vehicle control device comprising:
a backboard that is fixed to a back portion of the housing, allows circuit boards to be detachably fitted via a coupling mechanism, and connects a power source and a signal; and
the plurality of circuit boards that are electrically connected to the backboard via the coupling mechanism, the plurality of the circuit boards each being detachably fitted.

3. The on-vehicle control device according to claim 2, wherein
the housing is a sub-rack.

4. The on-vehicle control device according to claim 3, comprising:
two calculation boards having the same configuration,
a control unit of a first section and a control unit of a second section each having the calculation board are disposed in the one sub-rack,
fail-safe calculation units of double sections, in which when one of the first section and the second section fails, a calculation result of the other section is used for control, are constituted,
the calculation boards configured to perform the calculation processing for the sections, respectively, and the output boards configured to output the calculation result are provided,
a common interface for connecting the calculation result generated by control boards of the control unit of the first section and the control unit of the second section to the outside, and
the common interface is mounted at one position of the aggregate.

5. The on-vehicle control device according to claim 4, wherein
the calculation board and the output board constituting the control unit of the first section and
the calculation board and the output board constituting the control unit of the second section are
disposed in a laterally symmetrical manner in the sub-rack, and
the common interface is disposed between the control unit of the first section and the control unit of the second section.

6. The on-vehicle control device according to claim 4, wherein
the calculation board and the output board constituting the control unit of the first section and
the calculation board and the output board constituting the control unit of the second section are
disposed so as to be vertically disposed in the same array in the sub-rack, and
the common interface is disposed at an end portion of the sub-rack so as to be adjacent to each of the control unit of the first section and the control unit of the second section.
